# EUROPEAN PATENT APPLICATION

(11) **EP 4 108 729 A1**
(43) Date of publication of application: **28.12.2022**
(21) Application number: 21756297.4
(22) Date of filing: 08.02.2021
(51) Int. Cl.: C08L 101/00, C09D 11/00, H01L 51/48

(54) **INK COMPOSITION AND METHOD FOR PRODUCING SAME**

(30) Priority: 19.02.2020 JP 2020026214
(71) Applicant: SUMITOMO CHEMICAL COMPANY, LIMITED, Tokyo 103-6020 (JP)
(72) Inventor: INOKUCHI, Daisuke, Osaka-shi, Osaka 554-8558 (JP); ISHINO, Yuta, Osaka-shi, Osaka 554-8558 (JP)
(74) Representative: Vossius & Partner Patentanwälte Rechtsanwälte mbB
(86) International application number: PCT/JP2021/004519
(87) International publication number: WO 2021/166708

(57) **Abstract**

The present invention further improves the measurement accuracy of the viscosity of an ink composition. An ink composition for forming a functional layer of an organic photoelectric conversion element, wherein an electron spin concentration per 1 L of volume of the ink composition is 250 × 10¹⁶ or less. The ink composition may be an ink composition containing a solvent and a p-type semiconductor material. The ink composition may be an ink composition in which the p-type semiconductor material contains a polymer compound having an electron spin concentration per 1 g of weight of 70 × 10¹⁶ or less. The ink composition may be an ink composition in which the solvent contains one or more types of organic solvents and the p-type semiconductor material contains a π-conjugated polymer compound containing a donor constitutional unit and an acceptor constitutional unit.

## Description

### TECHNICAL FIELD

The present invention relates to an ink composition for forming a functional layer of an organic photoelectric conversion element and a method for producing the ink composition.

### BACKGROUND ART

Organic photoelectric conversion elements are an extremely useful device in view of, for example, energy saving and reduction in discharge amount of carbon dioxide, and therefore have attracted attention.

In the production of an organic photoelectric conversion element or an organic electroluminescent element, a production method is employed in which functional layers including an intermediate layer such as an electron transportation layer and a hole transportation layer, in addition to an active layer are formed by a coating method of applying an ink composition to an object to be coated.

For example, in a composition used for producing an organic electroluminescent element which has high luminous efficiency, can be driven at a low voltage, and has a long drive life, it is known that the number of electron spins per 1 mg is set to 1 × 10¹⁵ or more (see, Patent Document 1) .

### PRIOR ART DOCUMENTS

### PATENT DOCUMENTS

Patent Document 1: JP-A-2010-206120

### SUMMARY OF THE INVENTION

### PROBLEMS TO BE SOLVED BY THE INVENTION

The functional layer of the organic photoelectric conversion element as described above is formed by, for example, a coating method such as a slot die coating method. For example, in the slot die coating method, even when the ink composition is applied under the same coating condition, functional layers having different thicknesses may be formed according to the viscosity of the ink composition. Therefore, in order to form a functional layer having a desired thickness, it is necessary to adjust the coating condition such as the slit width of the nozzle according to the viscosity of the ink composition measured in advance. Therefore, it is necessary to accurately measure the viscosity of the ink composition.

However, in a case where the measurement accuracy of the viscosity of the ink composition is low, when the viscosity of the same ink composition is measured a plurality of times, the measured value varies, and the coefficient of variation (CV) increases. If the viscosity of the ink composition cannot be measured with high accuracy and the accurate viscosity cannot be grasped, accurate coating conditions for achieving a desired thickness cannot be set. As a result, the functional layer cannot be formed with a desired thickness set in advance.

Therefore, further improvement in the measurement accuracy of the viscosity of the ink composition to be applied to the coating method has been required.

### MEANS FOR SOLVING THE PROBLEMS

The present inventors have intensively studied to solve the above problems, and found that the measurement accuracy of the viscosity of the ink composition correlates with the electron spin concentration of the ink composition, thereby completing the present invention.

That is, the present invention provides the following [1] to [10] .
[1] An ink composition for forming a functional layer of an organic photoelectric conversion element, wherein an electron spin concentration per 1 L of volume of the ink composition is 250 × 10¹⁶ or less.
[2] The ink composition according to [1], containing a solvent and a p-type semiconductor material.
[3] The ink composition according to [1] or [2], wherein the p-type semiconductor material contains a polymer compound having an electron spin concentration per 1 g of weight of 70 × 10¹⁶ or less.
[4] The ink composition according to any one of [1] to [3], wherein
   the solvent contains one or more types of organic solvents, and
   the p-type semiconductor material contains a n-conjugated polymer compound containing a donor constitutional unit and an acceptor constitutional unit.
[5] The ink composition according to any one of [1] to [4], further containing
   an n-type semiconductor material, wherein
   the functional layer is an active layer.
[6] The ink composition according to any one of [1] to [5], wherein the solvent contains an organic solvent having a relative amount value of peroxide of 0.2 (%) or less based on an area value measured by a liquid chromatography apparatus.
[7] The ink composition according to any one of [1] to [4], wherein the solvent contains a compound represented by following Formula (1): 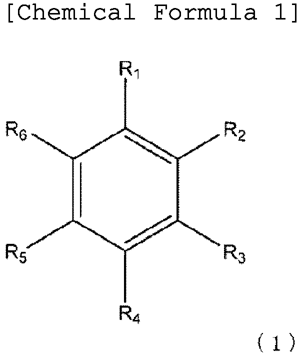 where R₁, R₂, R₃, R₄, R₅, and R₆ each independently represent a hydrogen atom, an alkyl group, or a cycloalkyl group, and two adjacent groups among R₁, R₂, R₃, R₄, R₅, and R₆ may be bonded to each other to form a ring.
[8] A method for producing an ink composition for forming a functional layer of an organic photoelectric conversion element, including a step of dissolving a p-type semiconductor material containing a polymer compound having an electron spin concentration per 1 g of weight of 70 × 10¹⁶ or less in a solvent.
[9] The method for producing an ink composition according to [8], wherein the ink composition is an ink composition having an electron spin concentration per 1 L of volume of 250 × 10¹⁶ or less.
[10] The method for producing an ink composition according to [8] or [9], wherein the solvent contains an organic solvent having a relative amount value of peroxide of 0.2 (%) or less based on an area value measured by a liquid chromatography apparatus.

### EFFECT OF THE INVENTION

According to the ink composition for forming a functional layer of an organic photoelectric conversion element according to the present invention, the accuracy of viscosity measurement of the ink composition can be further improved. As a result, it becomes easier to determine the coating conditions in the coating method, and as a result, the thickness of the functional layer can be set to a desired thickness set in advance with high accuracy.

### BRIEF DESCRIPTION OF THE DRAWINGS

Fig. 1 is a photograph for evaluating an undissolved residue of an ink composition of Example 1.
Fig. 2 is a photograph for evaluating an undissolved residue of an ink composition of Comparative Example 1.

### MODE FOR CARRYING OUT THE INVENTION

Hereinafter, an ink composition according to an embodiment of the present invention will be described. Note that the present invention is not limited at all by the following description. The constituent elements and the like according to an embodiment of the present invention can be appropriately changed without departing from the gist of the present invention.

### 1. Explanation of common terms

The "polymer compound" refers to a polymer having molecular weight distribution and having a number average molecular weight of 1 × 10³ or more and 1 × 10⁸ or less in terms of polystyrene. The constitutional units contained in the polymer compound are 100 mol% in total.

The "constitutional unit" refers to one or more units present in a polymer compound.

The "hydrogen atom" may be a light hydrogen atom or a heavy hydrogen atom.

The "halogen atom" includes a fluorine atom, a chlorine atom, a bromine atom, and an iodine atom.

The expression "may have a substituent" includes both aspects of a case where all the hydrogen atoms constituting the compound or group are not substituted and a case where some or all of one or more hydrogen atoms are substituted with a substituent.

The substituent is a monovalent group, and unless otherwise specified, is, for example, a halogen atom, an alkyl group (cycloalkyl group), an aryl group, an alkoxy group (cycloalkyloxy group), an aryloxy group, an alkylthio group, an arylthio group, a monovalent heterocyclic group, a substituted amino group, an acyl group, an imine residue, an amide group, an acid imide group, a substituted oxycarbonyl group, an alkenyl group, an alkynyl group, a cyano group, or a nitro group.

The "alkyl group" may be any of straight-chain, branched, or cyclic unless otherwise specified. The number of carbon atoms of the straight-chain alkyl group does not include the number of carbon atoms of the substituent, and is usually 1 to 50, preferably 1 to 30, and more preferably 1 to 20. The number of carbon atoms of each of the branched and cyclic alkyl groups does not include the number of carbon atoms of the substituent, and is usually 3 to 50, preferably 3 to 30, and more preferably 4 to 20.

The alkyl group may have a substituent. Specific examples of the alkyl group include a methyl group, an ethyl group, an n-propyl group, an isopropyl group, an n-butyl group, an isobutyl group, a tert-butyl group, an n-pentyl group, an isoamyl group, a 2-ethyl butyl group, an n-hexyl group, a cyclohexyl group, an n-heptyl group, a cyclohexylmethyl group, a cyclohexylethyl group, an n-octyl group, a 2-ethylhexyl group, a 3-n-propylheptyl group, an adamantyl group, an n-decyl group, a 3,7-dimethyloctyl group, a 2-ethyloctyl group, a 2-n-hexyl-decyl group, an n-dodecyl group, a tetradecyl group, a hexadecyl tomb, an octadecyl group, and an eicosyl group.

Examples of the alkyl group having a substituent include an alkyl group in which one or more hydrogen atoms are substituted with a fluorine atom (for example, a trifluoromethyl group, a pentafluoroethyl group, a 4,4,4,-trifluorobutyl group, a group represented by -CH₂-(CF₂)₂-CF₃, a group represented by -(CF₂)₂-CH₂-CF₃, a perfluorobutyl group, a perfluorohexyl group, and a perfluorooctyl group), an alkyl group in which one or more hydrogen atoms are substituted with a chlorine atom (for example, a trichloromethyl group, and a 4,4,4-trichlorobutyl group), an alkyl group in which a hydrogen atom is substituted with an alkyloxy group, such as a 6-ethyloxyhexyl group, and an alkyl group in which a hydrogen atom is substituted with an aryl group, such as a 3-phenylpropyl group, a 3-(4-methylphenyl)propyl group, and a 3-(3,5-di-n-hexylphenyl)propyl group.

The "cycloalkyl group" may be a monocyclic group or a polycyclic group. The cycloalkyl group may have a substituent. The number of carbon atoms of the cycloalkyl group does not include the number of carbon atoms of the substituent, and is usually 3 to 30.

Specific examples of the cycloalkyl group include a cyclopentyl group, a cyclohexyl group, a cycloheptyl group, and an adamantyl group.

Examples of the cycloalkyl group having a substituent include a cycloalkyl group in which one or more hydrogen atoms are substituted with a fluorine atom, a cycloalkyl group in which one or more hydrogen atoms are substituted with an alkyl group, and a cycloalkyl group in which one or more hydrogen atoms are substituted with an alkyloxy group.

The "aryl group" refers to a remaining atomic group in which one hydrogen atom directly bonded to a carbon atom constituting a ring is removed from an aromatic hydrocarbon which may have a substituent.

The aryl group may have a substituent. Specific examples of the aryl group include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group, a 4-phenylphenyl group, and a group in which a hydrogen atom of each of these groups is substituted with an alkyl group, an alkoxy group, an aryl group, a fluorine atom, or the like.

The "alkoxy group" may be any of straight-chain, branched, and cyclic. The number of carbon atoms of the straight-chain alkoxy group does not include the number of carbon atoms of the substituent, and is usually 1 to 40, and preferably 1 to 10. The number of carbon atoms of the branched or cyclic alkoxy group does not include the number of carbon atoms of the substituent, and is usually 3 to 40, and preferably 4 to 10.

The alkoxy group may have a substituent. Specific examples of the alkoxy group include a methoxy group, an ethoxy group, an n-propyloxy group, an isopropyloxy group, an n-butyloxy group, an isobutyloxy group, a tert-butyloxy group, an n-pentyloxy group, an n-hexyloxy group, a cyclohexyloxy group, an n-heptyloxy group, an n-octyloxy group, a 2-ethylhexyloxy group, an n-nonyloxy group, an n-decyloxy group, a 3,7-dimethyloctyloxy group, and a lauryloxy group.

The number of carbon atoms of the "aryloxy group" does not include the number of carbon atoms of the substituent, and is usually 6 to 60, and preferably 6 to 48.

The aryloxy group may have a substituent. Specific examples of the aryloxy group include a phenoxy group, a 1-naphthyloxy group, a 2-naphthyloxy group, a 1-anthracenyloxy group, a 9-anthracenyloxy group, a 1-pyrenyloxy group, and a group in which a hydrogen atom of each of these groups is substituted with an alkyl group, an alkoxy group, a fluorine atom, or the like.

The "alkylthio group" may be any of straight-chain, branched, and cyclic. The number of carbon atoms of the straight-chain alkylthio group does not include the number of carbon atoms of the substituent, and is usually 1 to 40, and preferably 1 to 10. The number of carbon atoms of the branched or cyclic alkylthio group does not include the number of carbon atoms of the substituent, and is usually 3 to 40, and preferably 4 to 10.

The alkylthio group may have a substituent. Specific examples of the alkylthio group include a methylthio group, an ethylthio group, a propylthio group, an isopropylthio group, a butylthio group, an isobutylthio group, a tert-butylthio group, a pentylthio group, a hexylthio group, a cyclohexylthio group, a heptylthio group, an octylthio group, a 2-ethylhexylthio group, a nonylthio group, a decylthio group, a 3,7-dimethyloctylthio group, a laurylthio group, and a trifluoromethylthio group.

The number of carbon atoms of the "arylthio group" does not include the number of carbon atoms of the substituent, and is usually 6 to 60, and preferably 6 to 48.

The arylthio group may have a substituent. Examples of the arylthio group include a phenylthio group, a C1-C12 alkyloxyphenylthio group (C1-C12 represents that the number of carbon atoms of a group described immediately after this description is 1 to 12, the same applies hereinafter.), a C1-C12 alkylphenylthio group, a 1-naphthylthio group, a 2-naphthylthio group, and a pentafluorophenyl thio group.

The "p-valent heterocyclic group" (p represents an integer of 1 or more.) refers to a remaining atomic group in which p hydrogen atoms among hydrogen atoms directly bonded to a carbon atom or heteroatom constituting a ring are removed from a heterocyclic compound which may have a substituent. Among the p-valent heterocyclic groups, "p-valent aromatic heterocyclic groups" are preferable.

The "p-valent aromatic heterocyclic group" refers to a remaining atomic group in which p hydrogen atoms among hydrogen atoms directly bonded to a carbon atom or heteroatom constituting a ring are removed from an aromatic heterocyclic compound which may have a substituent.

The aromatic heterocyclic compound includes compounds in which a heterocyclic ring itself exhibits no aromaticity and an aromatic ring is condensed to the heterocyclic ring, in addition to compounds in which a heterocyclic ring itself exhibits aromaticity.

Among the aromatic heterocyclic compounds, specific examples of the compound in which a heterocyclic ring itself exhibits aromaticity include oxadiazole, thiadiazole, thiazole, oxazole, thiophene, pyrrole, phosphole, furan, pyridine, pyrazine, pyrimidine, triazine, pyridazine, quinoline, isoquinoline, carbazole, and dibenzophosphole.

Among the aromatic heterocyclic compounds, specific examples of the compound in which an aromatic heterocyclic ring itself exhibits no aromaticity and an aromatic ring is condensed to the heterocyclic ring include phenoxazine, phenothiazine, dibenzoborole, dibenzosilole, and benzopyran.

The number of carbon atoms of the monovalent heterocyclic group does not include the number of carbon atoms of the substituent, and is usually 2 to 60, and preferably 4 to 20.

The monovalent heterocyclic group may have a substituent, and specific examples of the monovalent heterocyclic group include a thienyl group, a pyrrolyl group, a furyl group, a pyridyl group, a piperidyl group, a quinolyl group, an isoquinolyl group, a pyrimidinyl group, a triazinyl group, and a group in which a hydrogen atom of each of these groups is substituted with an alkyl group, an alkoxy group, or the like.

The "substituted amino group" refers to an amino group having two substituents. Examples of the substituent that can be included in the amino group include an alkyl group, an aryl group, and a monovalent heterocyclic group, and an alkyl group, an aryl group, or a monovalent heterocyclic group is preferable. The number of carbon atoms of the substituted amino group is usually 2 to 30.

Examples of the substituted amino group include dialkylamino groups such as a dimethylamino group, and a diethylamino group; and diarylamino groups such as a diphenylamino group, a bis(4-methylphenyl)amino group, a bis(4-tert-butylphenyl)amino group, and a bis(3,5-di-tert-butylphenyl)amino group.

The number of carbon atoms of the "acyl group" is usually 2 to 20, and preferably 2 to 18. Specific examples of the acyl group include an acetyl group, a propionyl group, a butyryl group, an isobutyryl group, a pivaloyl group, a benzoyl group, a trifluoroacetyl group, and a pentafluorobenzoyl group.

The "imine residue" refers to a remaining atomic group in which one hydrogen atom directly bonded to a carbon atom or a nitrogen atom constituting a carbon atom-nitrogen atom double bond is removed from an imine compound. The "imine compound" refers to an organic compound having a carbon atom-nitrogen atom double bond in the molecule. Examples of the imine compound include aldimine, ketimine, and compounds in which a hydrogen atom bonded to a nitrogen atom constituting a carbon atom-nitrogen atom double bond in aldimine is substituted with an alkyl group or the like.

The number of carbon atoms of the imine residue is usually from 2 to 20, and preferably 2 to 18. Examples of the imine residue include groups represented by the following structural formula.

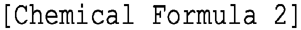

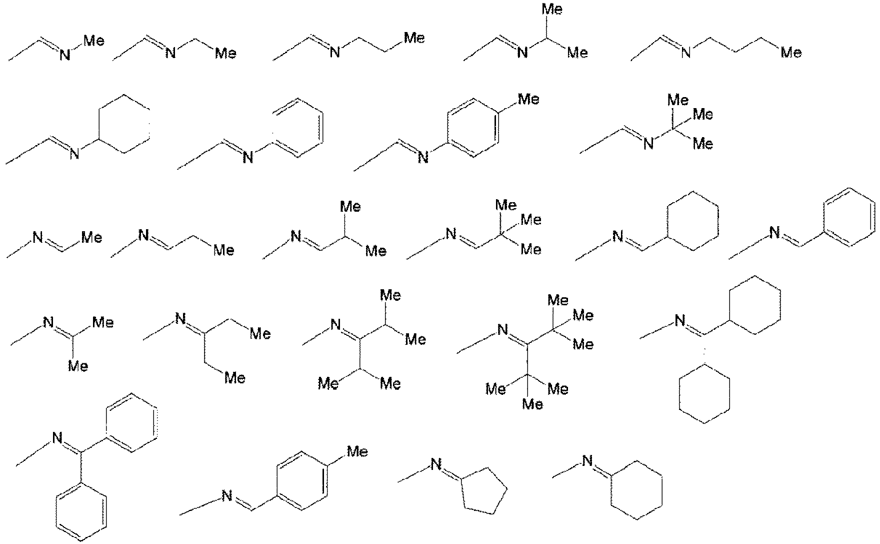

The "amide group" refers to a remaining atomic group in which one hydrogen atom bonded to a nitrogen atom is removed from amide. The number of carbon atoms of the amide group is usually approximately 1 to 20, and preferably 1 to 18. Specific examples of the amide group include a formamide group, an acetamide group, a propioamide group, a butyroamide group, a benzamide group, a trifluoroacetamide group, a pentafluorobenzamide group, a diformamide group, a diacetamide group, a dipropioamide group, a dibutyroamide group, a dibenzamide group, a ditrifluoroacetamide group, and a dipentafluorobenzamide group.

The "acid imide group" refers to a remaining atomic group in which one hydrogen atom bonded to a nitrogen atom is removed from acid imide. The number of carbon atoms of the acid imide group is usually 4 to 20. Specific examples of the acid imide group include the following groups.

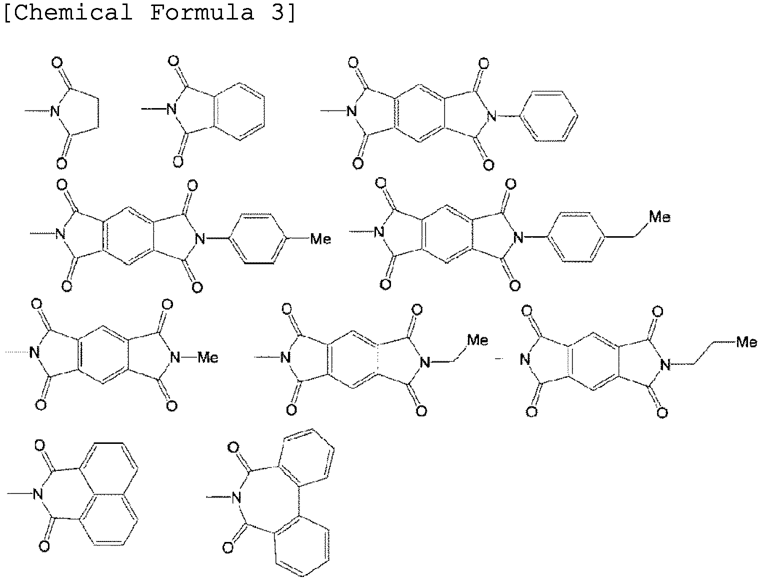

The "substituted oxycarbonyl group" refers to a group represented by R'-O-(C=O)-.

Here, R' represents an alkyl group, an aryl group, an arylalkyl group, or a monovalent heterocyclic group.

The number of carbon atoms of the "substituted oxycarbonyl group" is usually 2 to 60, and preferably 2 to 48.

Specific examples of the substituted oxycarbonyl group include a methoxycarbonyl group, an ethoxycarbonyl group, a propoxycarbonyl group, an isopropoxycarbonyl group, a butoxycarbonyl group, an isobutoxycarbonyl group, a tert-butoxycarbonyl group, a pentyloxycarbonyl group, a hexyloxycarbonyl group, a cyclohexyloxycarbonyl group, a heptyloxycarbonyl group, an octyloxycarbonyl group, a 2-ethylhexyloxycarbonyl group, a nonyloxycarbonyl group, a decyloxycarbonyl group, a 3,7-dimethyloctyloxycarbonyl group, a dodecyloxycarbonyl group, a trifluoromethoxycarbonyl group, a pentafluoroethoxycarbonyl group, a perfluorobutoxycarbonyl group, a perfluorohexyloxycarbonyl group, a perfluorooctyloxycarbonyl group, a phenoxycarbonyl group, a naphthoxycarbonyl group, and a pyridyloxycarbonyl group.

The "alkenyl group" may be any of straight-chain, branched, and cyclic. The number of carbon atoms of the straight-chain alkenyl group does not include the number of carbon atoms of the substituent, and is usually 2 to 30, and preferably 3 to 20. The number of carbon atoms of the branched or cyclic alkenyl group does not include the number of carbon atoms of the substituent, and is usually 3 to 30, and preferably 4 to 20.

The alkenyl group may have a substituent. Specific examples of the alkenyl group include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group, a 7-octenyl group, and a group in which a hydrogen atom of each of these groups is substitute with an alkyl group, an alkoxy group, or the like.

The "alkynyl group" may be any of straight-chain, branched, and cyclic. The number of carbon atoms of the straight-chain alkenyl group does not include the number of carbon atoms of the substituent, and is usually 2 to 20, and preferably 3 to 20. The number of carbon atoms of the branched or cyclic alkenyl group does not include the number of carbon atoms of the substituent, and is usually 4 to 30, and preferably 4 to 20.

The alkynyl group may have a substituent. Specific examples of the alkynyl group include an ethynyl group, a 1-propynyl group, a 2-propynyl group, a 2-butynyl group, a 3-butynyl group, a 3-pentynyl group, a 4-pentynyl, a 1-hexenyl group, a 5-hexenyl group, and a group in which a hydrogen atom of each of these groups is substituted with an alkyl group, an alkoxy group, or the like.

The "ink composition" means a liquid composition used in a coating method, and is not limited to a colored liquid composition.

The "coating method" comprehensively includes a method of forming a film using a liquid substance. Examples of the coating method include a slit coating method, a knife coating method, a spin coating method, a casting method, a micro gravure coating method, a gravure coating method, a bar coating method, a roll coating method, a wire bar coating method, a dip coating method, a spray coating method, a screen printing method, a gravure printing method, a flexo printing method, an offset printing method, an inkjet coating method, a dispenser printing method, a nozzle coating method, a capillary coating method, and a slot die coating method.

The "ink composition" may be a solution, a dispersion, or a dispersion such as an emulsion and a suspension.

### 2. Ink composition

The ink composition according to the present embodiment is an ink composition that is used for forming a functional layer of an organic photoelectric conversion element and that has an electron spin concentration per 1 L of volume (10⁻³m³) (Spin/L) of 250 × 10¹⁶ or less. A specific configuration of the organic photoelectric conversion element will be described later.

Here, the "electron spin concentration per 1 L of volume" in the ink composition can be specifically calculated as an electron spin concentration per 1 L (Spin/L) of the ink composition by performing ESR measurement with any preferred commercially available ESR apparatus (for example, "X-band ESR apparatus" manufactured by JEOL Ltd.) to acquire an ESR spectrum, quantifying the amount of electron spin based on the area value of the obtained ESR spectrum, and dividing the obtained amount of electron spin by the weighed volume value of the ink composition.

In the present embodiment, the electron spin concentration per 1 L of volume (Spin/L) of the ink composition is preferably 250 × 10¹⁶ or less, more preferably 230 × 10¹⁶ or less, still more preferably 138 × 10¹⁶ or less, still even more preferably 73.2 × 10¹⁶ or less, and particularly preferably 61.8 × 10¹⁶ or less, from the viewpoint of further improving the accuracy of viscosity measurement of the ink composition.

The viscosity (mPa·s) of the ink composition can be set in consideration of a coating method, the thickness of a functional layer to be formed, coating conditions, and the like, and is not particularly limited, but is, for example, 50 or less.

Here, the viscosity of the ink composition can be measured, for example, for a prepared ink composition according to a conventional method using any preferred commercially available E-type viscometer (for example, "DV-2Pro" manufactured by Brookfield).

In an aspect, the ink composition of the present embodiment contains a solvent and a p-type semiconductor material. Such an ink composition can be suitably used for forming a bulk heterojunction-type active layer. Hereinafter, the p-type semiconductor material and the solvent that can be contained in the ink composition of the present embodiment will be described.

### (p-type semiconductor material)

In the present embodiment, the p-type semiconductor material preferably contains a polymer compound having an electron spin concentration per 1 g of weight of 70 × 10¹⁶ or less.

Here, the "electron spin concentration per 1 g of weight" can be specifically calculated as an electron spin concentration per 1 g (Spin/g) of the p-type semiconductor material by, for example, quantifying the amount of electron spin using a powdery p-type semiconductor material in the same manner as the above-described calculation of the "electron spin concentration per 1 L of volume " and dividing the obtained amount of electron spin by the weighed value of the p-type semiconductor material.

In the present embodiment, the p-type semiconductor material is preferably a π-conjugated polymer compound (also referred to as a D-A type conjugated polymer compound) containing a donor constitutional unit (also referred to as a D constitutional unit) and an acceptor constitutional unit (also referred to as an A constitutional unit).

Here, the donor constitutional unit is a constitutional unit in which π electrons are excessive, and the acceptor constitutional unit is a constitutional unit in which π electrons are deficient.

In the present embodiment, a constitutional unit that can constitute the p-type semiconductor material includes a constitutional unit in which a donor constitutional unit and an acceptor constitutional unit are directly bonded, and further includes a constitutional unit in which a donor constitutional unit and an acceptor constitutional unit are bonded via any preferred spacer (group or constitutional unit).

Such a D-A type conjugated polymer compound is degraded (radically cationized) under the influence of storage conditions such as the presence of oxygen in the atmosphere during storage and high temperature, and thus the spin concentration thereof tends to increase.

In the present embodiment, the p-type semiconductor material is more specifically, for example, preferably a polymer compound containing a constitutional unit having a structure in which bithiophene as a D constitutional unit is cyclized and a constitutional unit having a benzothiazole ring structure as an A constitutional unit. Hereinafter, the p-type semiconductor material of the present embodiment will be described.

Examples of the p-type semiconductor material according to the present embodiment include a polymer compound containing a constitutional unit (D constitutional unit) represented by the following Formula (I) and/or a constitutional unit (A constitutional unit) represented by the following Formula (II).

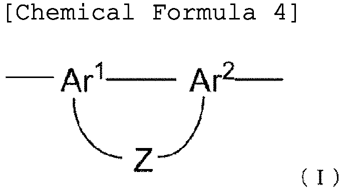

In Formula (I), Ar¹ and Ar² represent a trivalent aromatic heterocyclic group, and Z represents a group represented by the following Formulae (Z-1) to (Z-7).

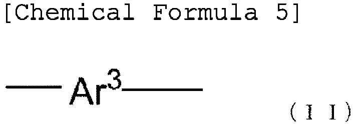

In Formula (II), Ar³ represents a divalent aromatic heterocyclic group.

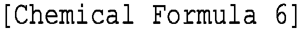

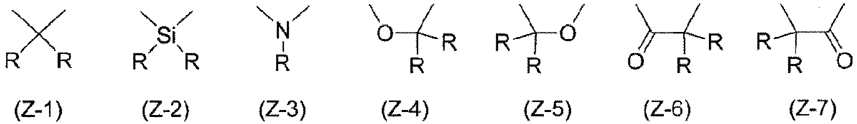

In Formulae (Z-1) to (Z-7), R represents a hydrogen atom, a halogen atom, an alkyl group, an aryl group, an alkoxy group, an aryloxy group, an alkylthio group, an arylthio group, a monovalent heterocyclic group, a substituted amino group, an acyl group, an imine residue, an amide group, an acid imide group, a substituted oxycarbonyl group, an alkenyl group, an alkynyl group, a cyano group, and a nitro group.

In each of Formulae (Z-1) to (Z-7), when there are two Rs, they may be the same or different from each other.

Examples of the constitutional unit represented by Formula (I) include constitutional units represented by the following Formula (I-1).

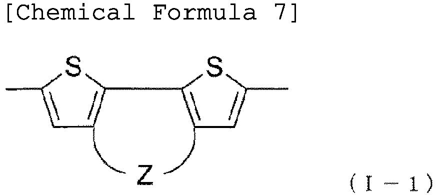

In Formula (I-1), Z represents the same meaning as described above.

Examples of the constitutional unit represented by Formula (I-1) include constitutional units represented by the following Formulae (501) to (505).

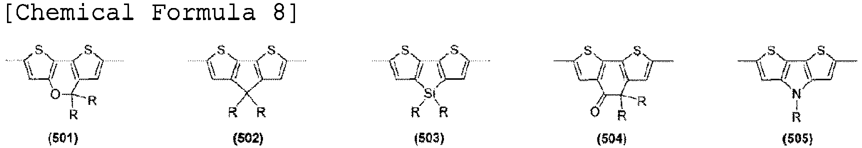

In Formulae (501) to (505), R represents the same meaning as described above. When there are two Rs, they may be the same or different from each other.

The number of carbon atoms of the divalent aromatic heterocyclic group represented by Ar³ is usually 2 to 60, preferably 4 to 60, and more preferably 4 to 20. The divalent aromatic heterocyclic group represented by Ar³ may have a substituent.

Examples of the substituent represented by Ar³ which may be included in the divalent aromatic heterocyclic group include a halogen atom, an alkyl group, an aryl group, an alkoxy group, an aryloxy group, an alkylthio group, an arylthio group, a monovalent heterocyclic group, a substituted amino group, an acyl group, an imine residue, an amide group, an acid imide group, a substituted oxycarbonyl group, an alkenyl group, an alkynyl group, a cyano group, and a nitro group.

Examples of the divalent aromatic heterocyclic group represented by Ar³ include groups represented by the following Formulae (101) to (185).

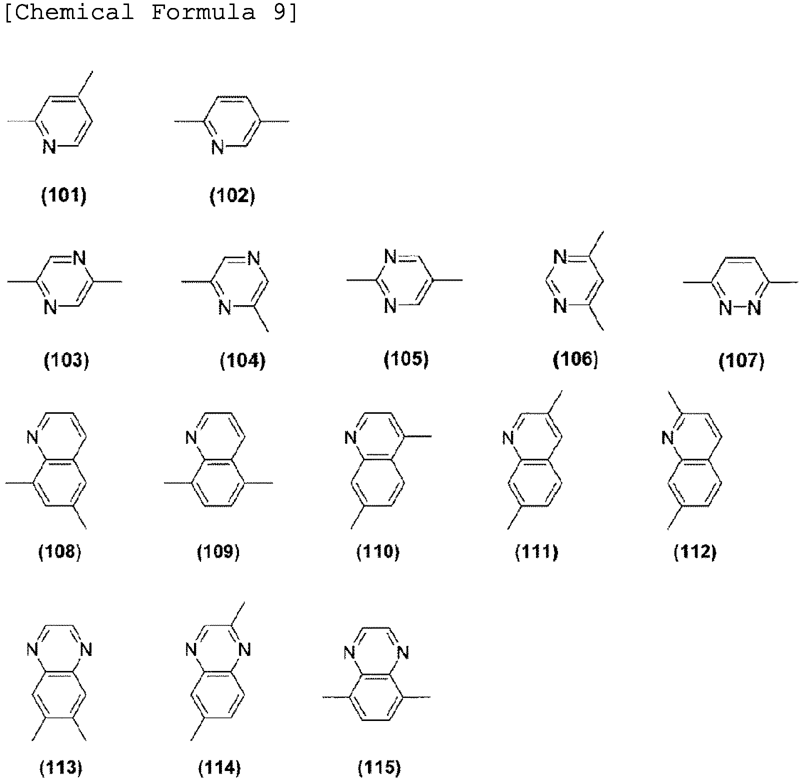

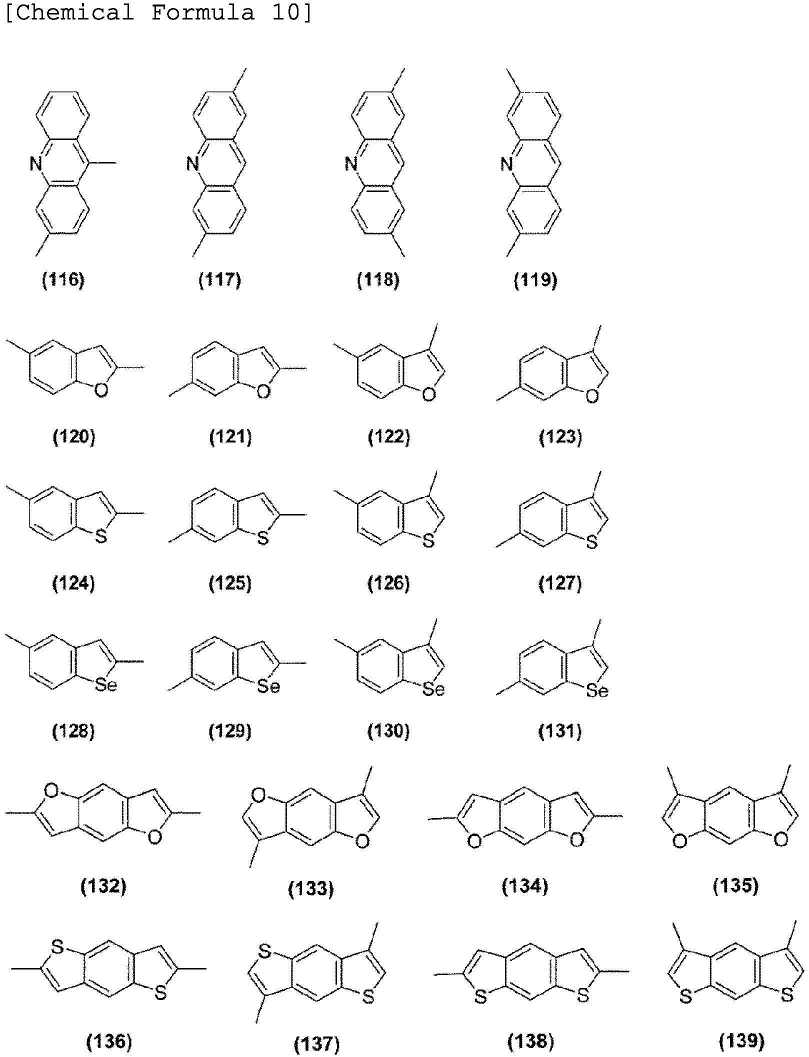

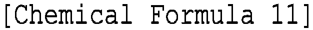

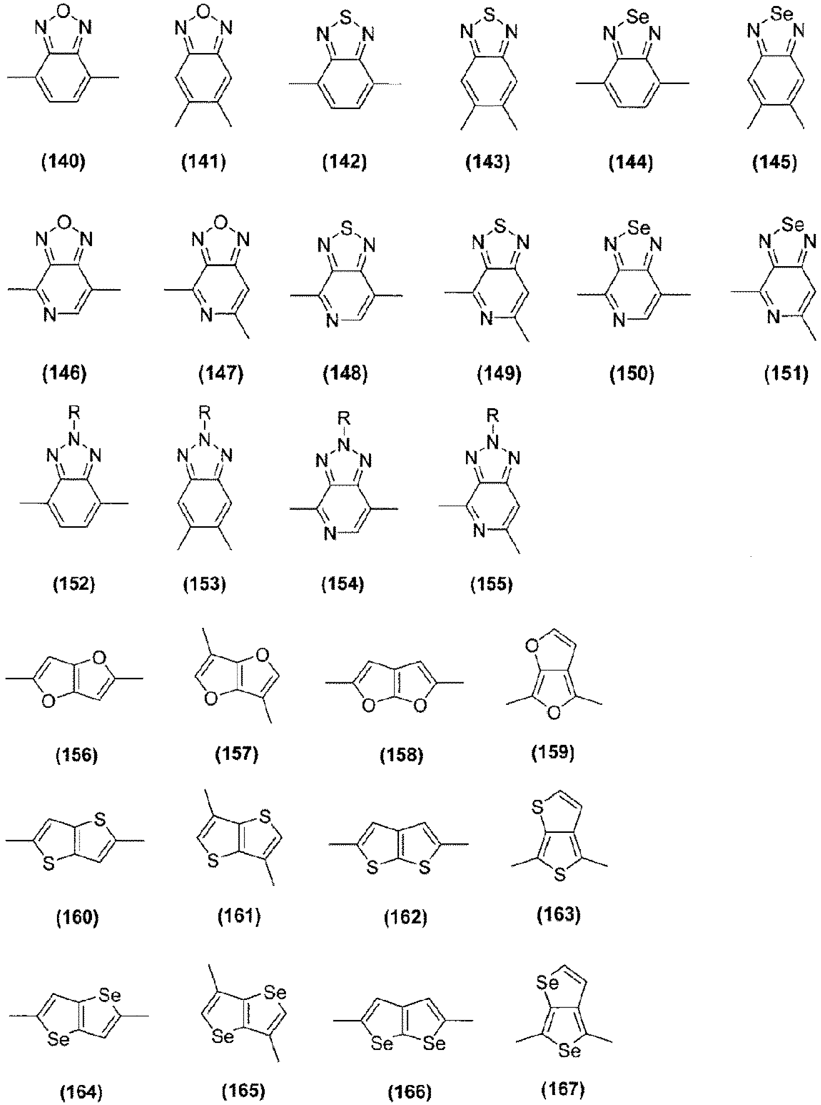

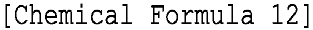

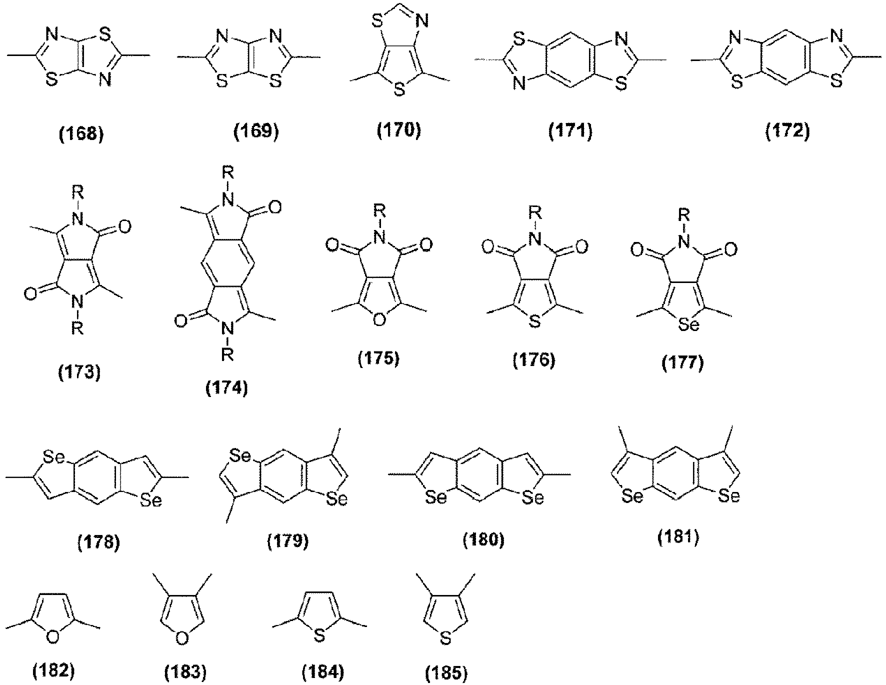

In Formulae (101) to (185), R represents the same meaning as described above. When there is a plurality of Rs, they may be the same or different from each other.

Examples of the constitutional unit represented by Formula (II) include constitutional units represented by the following Formulae (II-1) to (II-6).

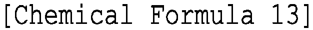

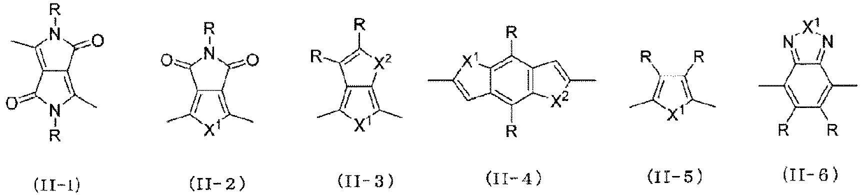

In Formulae (II-1) to (II-6), X¹ and X² each independently represent an oxygen atom or a sulfur atom, and R represents the same meaning as described above. When there is a plurality of Rs, they may be the same or different from each other.

X¹ and X² in Formulae (II-1) to (II-6) are both preferably a sulfur atom from the viewpoint of availability of raw material compounds.

The polymer compound which is a p-type semiconductor material of the present embodiment may contain two or more types of constitutional units of Formula (I), or may contain two or more types of constitutional units of Formula (II).

In the present embodiment, the polymer compound which is a p-type semiconductor material may contain a constitutional unit represented by the following Formula (III) .

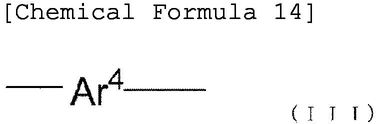

In Formula (III), Ar⁴ represents an arylene group.

The arylene group represented by Ar⁴ refers to a remaining atomic group in which two hydrogen atoms are removed from an aromatic hydrocarbon which may have a substituent. The aromatic hydrocarbon includes compounds having a condensed ring, and compounds in which two or more selected from the group consisting of independent benzene rings and condensed rings are directly bonded or bonded via a divalent group such as a vinylene group.

The number of carbon atoms of a moiety excluding the substituent in the arylene group is usually 6 to 60, and preferably 6 to 20. The upper limit of the number of carbon atoms of the arylene group including the substituent is approximately 100.

Examples of the arylene group include phenylene groups (for example, the following Formulae 1 to 3), naphthalenediyl groups (for example, the following Formulae 4 to 13), anthracendiyl groups (for example, the following Formulae 14 to 19), biphenyldiyl groups (for example, the following Formulae 20 to 25), terphenyldiyl groups (for example, the following Formulae 26 to 28), condensed-ring compound groups (for example, the following Formulae 29 to 35), fluorenediyl groups (for example, the following Formulae 36 to 38), and benzofluorenediyl groups (for example, the following Formulae 39 to 46).

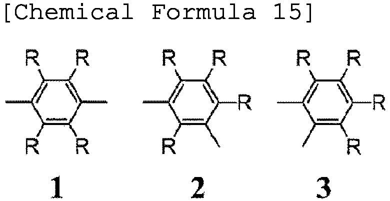

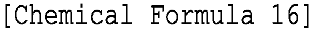

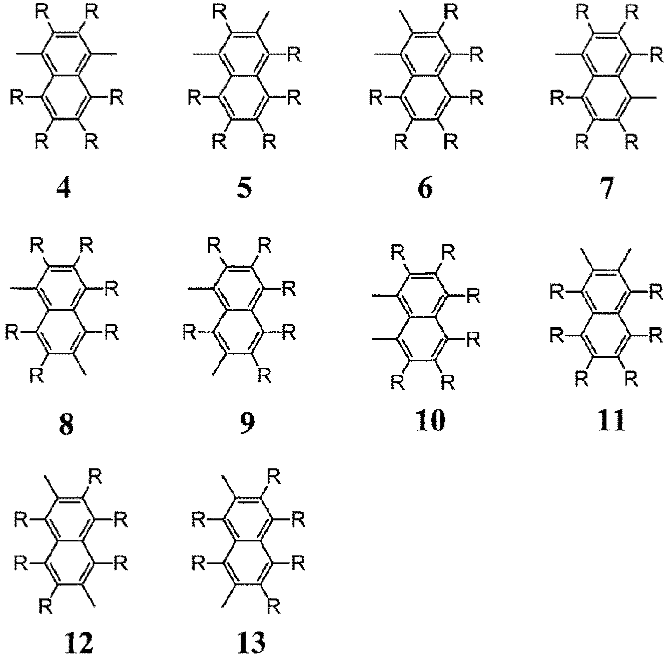

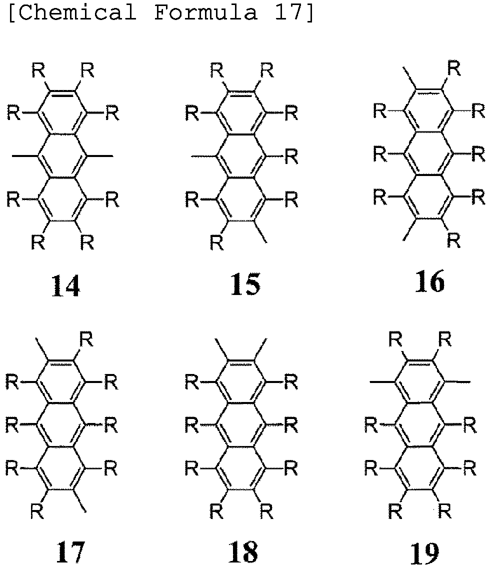

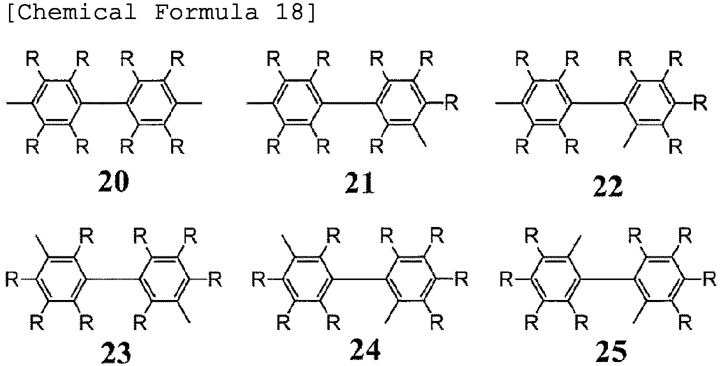

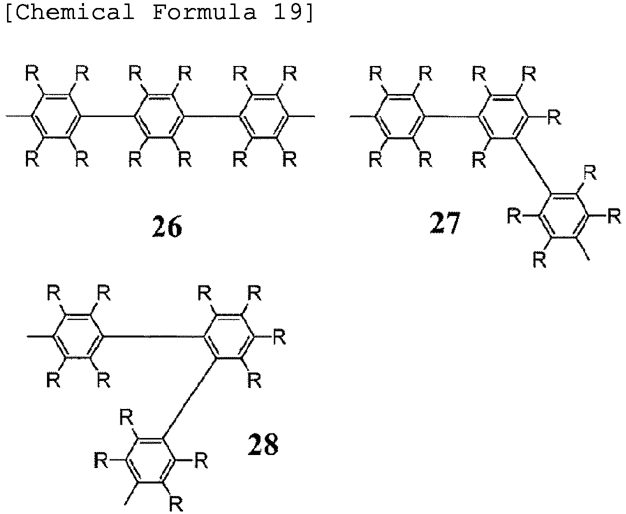

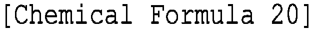

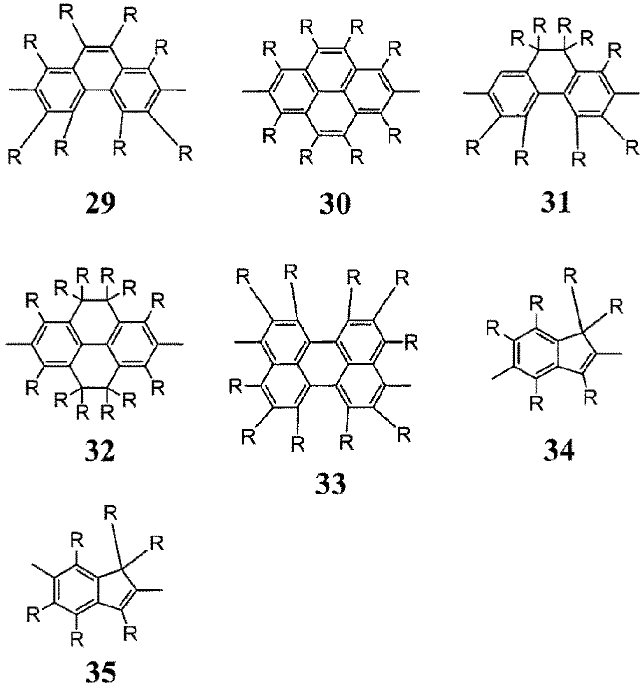

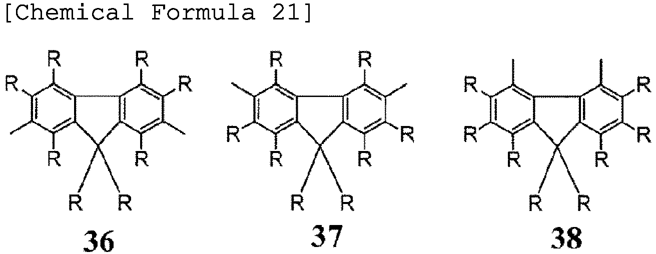

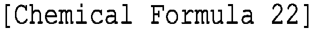

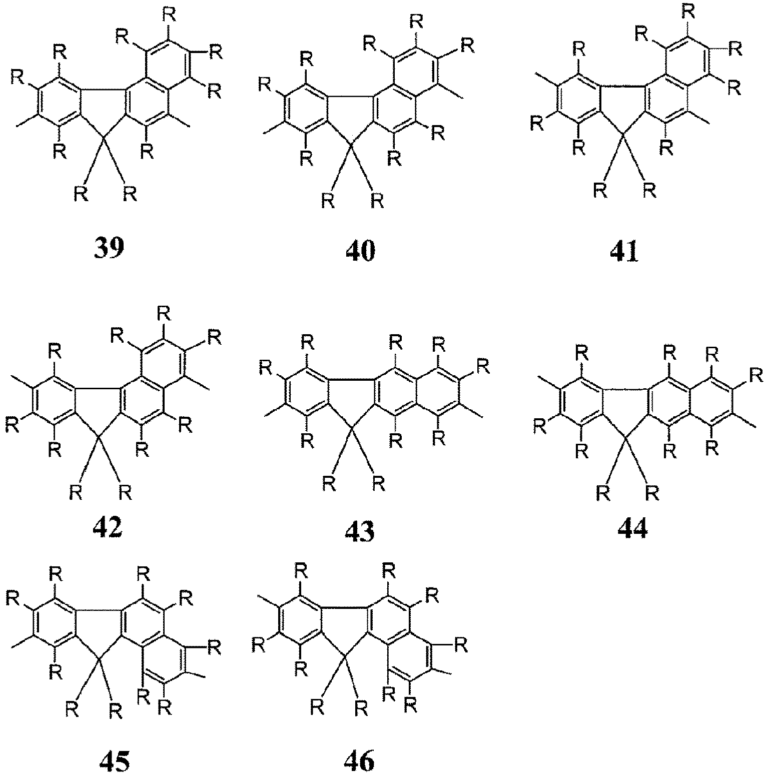

In Formula 1 to 46, R which is a substituent represents the same meaning as described above. A plurality of Rs may be the same or different from each other.

The constitutional unit that can constitute a polymer compound which is a p-type semiconductor material of the present embodiment may be a constitutional unit formed by combining two or more of two or more types of constitutional units selected from the constitutional unit represented by Formula (I), the constitutional unit represented by Formula (II), and the constitutional unit represented by Formula (III).

In a case where the polymer compound which is a p-type semiconductor material of the present embodiment contains the constitutional unit represented by Formula (I) and/or the constitutional unit represented by Formula (II), the total amount of the constitutional unit represented by Formula (I) and the constitutional unit represented by Formula (II) may be usually 20 to 100 mol% when the amount of all constitutional units contained in the polymer compound is 100 mol%. The total amount may also be 40 to 100 mol%, or 50 to 100 mol% from the viewpoint of improving charge transportability.

Specific examples of the polymer compound which is a p-type semiconductor material of the present embodiment include polymer compounds P-1 to P-3 represented by the following formula.

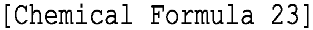

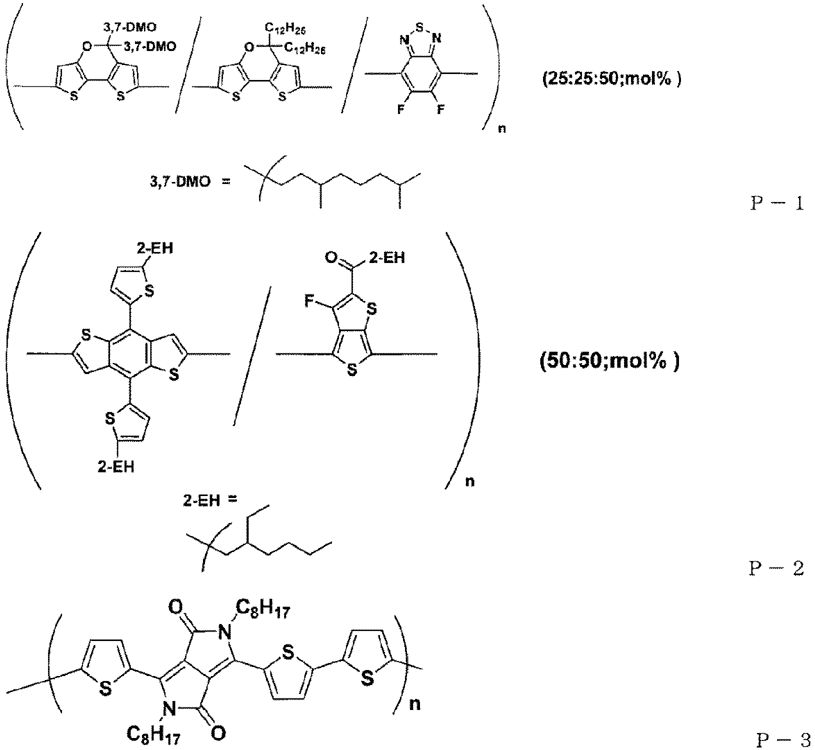

The polymer compound which is a p-type semiconductor material usually has a weight average molecular weight of 1 × 10³ to 1 × 10⁸ in terms of polystyrene. The polymer compound preferably has a weight average molecular weight of 1 × 10³ to 1 × 10⁶ from the viewpoint of improving solubility in a solvent.

### (Solvent)

Next, a solvent that can be used for the ink composition of the present embodiment will be described.

The solvent that can be used for the ink composition of the present embodiment contains one or more types of organic solvents.

In the present embodiment, the solvent (organic solvent) specifically preferably contains a compound represented by the following Formula (1).

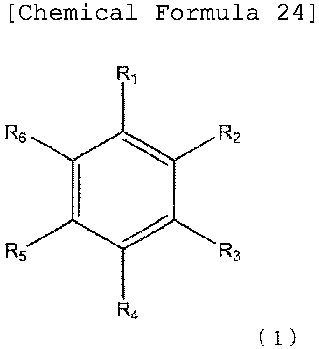

In Formula (1), R₁, R₂, R₃, R₄, R₅, and R₆ each independently represent a hydrogen atom, an alkyl group, or a cycloalkyl group. Two adjacent groups among R₁, R₂, R₃, R₄, R₅, and R₆ may be bonded to each other to form a ring.

The solvent of the present embodiment is a solvent capable of dissolving a p-type semiconductor material. Examples of such a solvent include toluene, xylenes (for example, o-xylene, m-xylene, and p-xylene), trimethylbenzenes (for example, mesitylene, and 1,2,4-trimethylbenzene (pseudocumene)), butylbenzenes (for example, n-butylbenzene, sec-butylbenzene, and tert-butylbenzene), tetralin, and indan.

In the present embodiment, the solvent may be composed of two or more types of organic solvents. The solvent of the present embodiment is preferably composed of only one type of compound represented by Formula (1).

In the present embodiment, the solvent is preferably one or more types selected from the group consisting of toluene, o-xylene, m-xylene, p-xylene, mesitylene, 1,2,4-trimethylbenzene, n-butylbenzene, sec-butylbenzene, tert-butylbenzene, tetralin, and indan, and more preferably toluene, o-xylene, m-xylene, p-xylene, mesitylene, 1,2,4-trimethylbenzene, n-butylbenzene, sec-butylbenzene, tert-butylbenzene, tetralin, or indan.

In the present embodiment, the solvent may be a mixed solvent containing a compound (solvent) other than the compound represented by the above Formula (1). The solvent other than the compound represented by the above Formula (1) is preferably a solvent capable of dissolving an n-type semiconductor material.

In the present embodiment, examples of the compound other than the compound represented by the above Formula (1) that can be contained in the solvent include aromatic carbonyl compounds, aromatic ester compounds, and nitrogen-containing heterocyclic compounds.

Examples of the aromatic carbonyl compound include acetophenone which may have a substituent, propiophenone which may have a substituent, butyrophenone which may have a substituent, cyclohexylphenone which may have a substituent, and benzophenone which may have a substituent.

Examples of the aromatic ester compound include methyl benzoate which may have a substituent, ethyl benzoate which may have a substituent, propyl benzoate which may have a substituent, butyl benzoate which may have a substituent, isopropyl benzoate which may have a substituent, benzyl benzoate which may have a substituent, cyclohexyl benzoate which may have a substituent, and phenyl benzoate which may have a substituent.

Examples of the nitrogen-containing heterocyclic compound include pyridine which may have a substituent, quinoline which may have a substituent, quinoxaline which may have a substituent, 1,2,3,4-tetrahydroquinoline which may have a substituent, pyrimidine which may have a substituent, pyrazine which may have a substituent, and quinazoline which may have a substituent.

The nitrogen-containing heterocyclic compound may have a substituent that is directly bonded to a ring structure.

Examples of the substituent that may be included in the ring structure (for example, quinoline ring structure, 1,2,3,4-tetrahydroquinoline ring structure, and quinoxaline ring structure) of the nitrogen-containing heterocyclic compound include an alkyl group having 1 to 5 carbon atoms, an alkoxy group having 1 to 5 carbon atoms, a halogen group, and an alkylthio group.

Examples of the nitrogen-containing heterocyclic compound having a pyridine ring structure include pyridine which may have a substituent, quinoline which may have a substituent, and isoquinoline which may have a substituent.

Examples of the nitrogen-containing cyclic compound having a pyrazine ring structure include pyrazine which may have a substituent and quinoxaline which may have a substituent.

Examples of the nitrogen-containing cyclic compound having a tetrahydropyridine ring structure include 1,2,3,4-tetrahydroquinoline which may have a substituent and 1,2,3,4-tetrahydroisoquinoline which may have a substituent.

Examples of the nitrogen-containing cyclic compound having a pyrimidine ring structure include pyrimidine which may have a substituent and quinazoline which may have a substituent.

In the present embodiment, the solvent may further contain only one type of aromatic carbonyl compound, aromatic ester compound, or nitrogen-containing heterocyclic compound, or may further contain two or more types selected from these compounds, in addition to the compound represented by the above Formula (1).

In the present embodiment, the solvent may contain any solvent other than the solvent described above. The content of any other solvent is preferably 5 wt.% or less, more preferably 3 wt.% or less, still more preferably 1 wt.% or less, and particularly preferably 0 wt.%, based on 100 wt.% of the total weight of all solvents contained in the ink composition.

The organic solvent that can be used for the ink composition of the present embodiment preferably contains an organic solvent in which the relative amount value of peroxide based on an area value measured by a liquid chromatography apparatus is 0.2 (%) or less, from the viewpoint of suppressing an increase in viscosity of the ink composition.

In the present embodiment, the relative amount value of peroxide (R) of the solvent is preferably 0.2 (%) or less, more preferably 0.1% or less, and still more preferably 0.02 (%) or less, from the viewpoint of suppressing an increase in viscosity of the ink composition.

In particular, the content of peroxide tends to increase over time in the solvent composed of the compound represented by Formula (1) described above. Therefore, it is preferable to select and use a solvent having a relative amount value of peroxide (R) of 0.2 (%) or less in the production of the ink composition.

The relative amount value of peroxide (R) of the solvent can be calculated based on an area value measured by a liquid chromatography apparatus.

Specifically, first, an ultraviolet-visible light chromatogram of the solvent is obtained through measurement, and an area value A of a peak derived from the solvent in the obtained ultraviolet-visible light chromatogram is calculated.

Next, a chemiluminescence chromatogram and an ultraviolet-visible light chromatogram of the solvent are obtained through measurement using a liquid chromatography apparatus equipped with a chemiluminescence detector and an ultraviolet-visible light detector. Then, an area value B of a peak of the solvent in the ultraviolet-visible light chromatogram having a retention time corresponding to a peak of the solvent in the chemiluminescence chromatogram is calculated.

Next, a value (%) obtained by multiplying the ratio (B/A) of the area value B to the area value A by 100 can be calculated as the relative amount value of peroxide (R).

In an aspect, the ink composition of the present embodiment may further contain an n-type semiconductor material in addition to the p-type semiconductor material described above. The ink composition containing a p-type semiconductor material and an n-type semiconductor material can be suitably used as an ink composition for forming, particularly, a bulk heterojunction-type active layer which is a functional layer of an organic photoelectric conversion element. Hereinafter, an n-type semiconductor material that can be contained in the ink composition of the present embodiment will be described.

When the ink composition contains a p-type semiconductor material and an n-type semiconductor material, whether the ink composition is a p-type semiconductor material or an n-type semiconductor material is relatively determined from the energy level of highest occupied molecular orbital (HOMO) or lowest unoccupied molecular orbital (LUMO) of the selected semiconductor material.

### (n-type semiconductor material)

The n-type semiconductor material (electron-accepting compound) may be a low molecular weight compound or a polymer compound.

Examples of the n-type semiconductor material which is a low molecular weight compound include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, fullerenes such as C₆₀ fullerene and derivatives thereof, and phenanthrene derivatives such as bathocuproine.

Examples of the n-type semiconductor material which is a polymer compound include polyvinylcarbazole and derivatives thereof, polysilane and derivatives thereof, polysiloxane derivatives having an aromatic amine structure in a side chain or the main chain, polyaniline and derivatives thereof, polythiophene and derivatives thereof, polypyrrole and derivatives thereof, polyphenylene vinylene and derivatives thereof, polythienylene vinylene and derivatives thereof, polyquinoline and derivatives thereof, polyquinoxaline and derivatives thereof, and polyfluorene and derivatives thereof.

The n-type semiconductor material is preferably one or more types selected from fullerenes and fullerene derivatives, and fullerene derivatives are more preferable.

Examples of the fullerene include C₆₀ fullerene, C₇₀ fullerene, C₇₆ fullerene, C₇₈ fullerene, and C₈₄ fullerene. Examples of the fullerene derivative include derivatives of these fullerenes. The fullerene derivative refers to a compound in which at least a part of fullerene has been modified.

Examples of the fullerene derivative include compounds represented by the following formula.

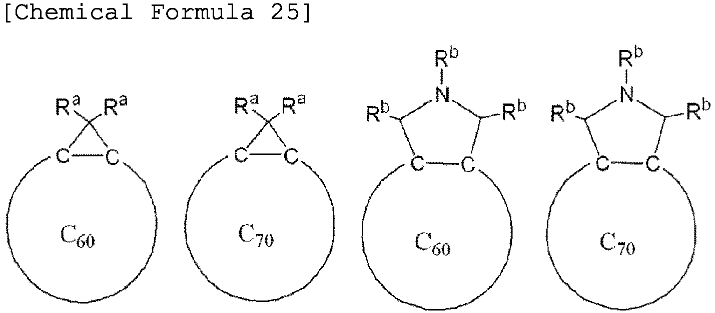

In the formula, R^{a} represents an alkyl group, an aryl group, a monovalent heterocyclic group, or a group having an ester structure. A plurality of R^{a}s may be the same or different from each other.

In the formula, R^{b} represents an alkyl group or an aryl group. A plurality of R^{b}s may be the same or different from each other.

Examples of the group having an ester structure represented by R^{a} include a group represented by the following Formula (19).

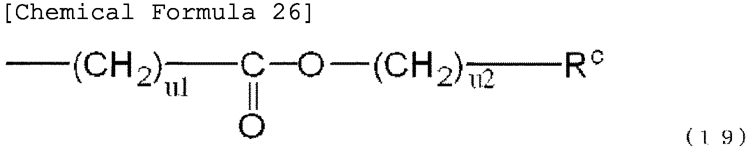

In Formula (19), u1 represents an integer of 1 to 6. u2 represents an integer of 0 to 6. R^{c} represents an alkyl group, an aryl group, or a monovalent heterocyclic group.

Examples of the C₆₀ fullerene derivative include the following compounds.

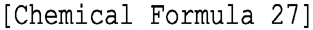

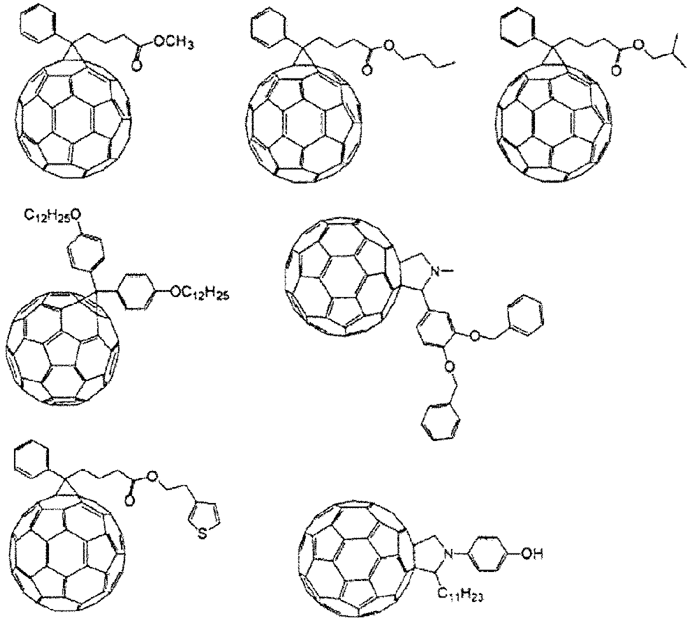

Examples of the C₇₀ fullerene derivative include the following compounds.

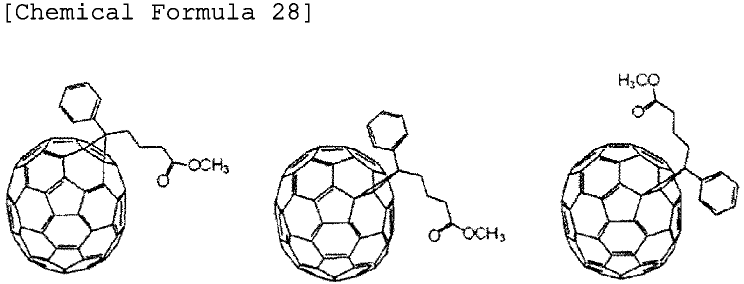

Specific examples of the fullerene derivative include [6,6]-phenyl-C61 butyric acid methyl ester (C60PCBM, [6,6]-Phenyl C61 butyric acid methyl ester), [6,6]-phenyl-C71 butyric acid methyl ester (C70PCBM, [6,6]-Phenyl C71 butyric acid methyl ester), [6,6-phenyl-C85 butyric acid methyl ester (C84PCBM, [6,6]-Phenyl C85 butyric acid methyl ester), and [6,6]-thienyl-C61 butyric acid methyl ester ([6,6]-Thienyl C61 butyric acid methyl ester).

In the present embodiment, the n-type semiconductor material is preferably a compound N-1 (C60PCBM) represented by the following formula.

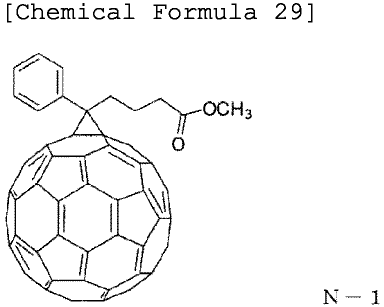

The ink composition of the present embodiment may contain only one type of n-type semiconductor material, or may contain a combination of two or more types at any ratio.

### 3. Method for producing ink composition

The method for producing an ink composition of the present embodiment is a method for producing an ink composition for forming a functional layer of an organic photoelectric conversion element. The method includes a step of dissolving a p-type semiconductor material containing a polymer compound having an electron spin concentration per 1 g of weight of 70 × 10¹⁶ or less described above in a solvent.

As described above, the ink composition produced by the method for producing an ink composition of the present embodiment has an electron spin concentration per 1 L of volume of 250 × 10¹⁶ or less.

The ink composition of the present embodiment can be produced by a known method.

For example, when a mixed solvent containing a plurality of types of solvents described above is used, a method can be employed in which the solvents are mixed to prepare a mixed solvent, and a p-type semiconductor material and an n-type semiconductor material are added to the mixed solvent to produce the ink composition. In addition, the ink composition can also be produced by adding a p-type semiconductor material to a solvent containing the compound represented by the above Formula (1), further adding an n-type semiconductor material to another solvent different from the solvent, and then mixing these.

In addition, the p-type semiconductor material and/or the n-type semiconductor material may be dissolved while the solvent and the semiconductor material(s) are heated to a temperature equal to or lower than the boiling point of the solvent.

After mixing of the first solvent and the second solvent, and the p-type semiconductor material and the n-type semiconductor material, the obtained composition is filtrated with a filter, and the filtrate may be used as ink. As the filter, a filter made of a fluororesin such as polytetrafluoroethylene (PTFE) can be used, for example.

The ink composition is applied to an object to be coated to form a coating film, and the solvent is then removed from the coating film to solidify the film, whereby a solidified film in which the ink composition has been cured can be obtained. Such a solidified film can suitably function as a functional layer of an organic photoelectric conversion element.

### 4. Organic photoelectric conversion element

In the present embodiment, the organic photoelectric conversion element includes a pair of electrodes including an anode and a cathode, and an active layer provided between the pair of electrodes and containing a p-type semiconductor material and/or an n-type semiconductor material which is an organic semiconductor material. Hereinafter, the organic photoelectric conversion element of the present embodiment will be described.

### (Substrate)

An organic photoelectric conversion element is typically formed on a substrate. Electrodes including a cathode and an anode are typically formed on the substrate. The material of the substrate is not particularly limited particularly as long as the material does not chemically change in the formation of a layer containing an organic compound. Examples of the material of the substrate include glass, plastic, a polymer film, and silicon. As the substrate, a substrate on which an electrode described later is formed or on which a layer of a conductive material that can function as an electrode is formed by patterning is provided can be prepared and used. Examples of the substrate on which a layer of a conductive material is provided include a glass substrate on which a layer of indium tin oxide (ITO) is formed.

### (Electrode)

Examples of the material of the transparent or translucent electrode include a conductive metal oxide film, and a translucent metal thin film. Specific examples thereof include conductive materials such as indium oxide, zinc oxide, tin oxide, and ITO, indium zinc oxide (IZO), and NESA which are composites thereof, gold, platinum, silver, and copper. As the material of the transparent or translucent electrode, ITO, IZO, and zinc oxide are preferable. Also, a transparent conductive film formed by using, as a material, an organic compound such as polyaniline and a derivative thereof, and polythiophene and a derivative thereof may be used as the electrode. The transparent or translucent electrode may be an anode or a cathode. In a case where the substrate is opaque, an electrode opposite to an electrode provided on the opaque substrate side (that is, an electrode provided far from the substrate) is preferably a transparent or translucent electrode.

If one electrode out of a pair of electrodes is transparent or translucent, the other electrode may be an electrode with low light transmittance. Examples of the material of the electrode with low light transmittance include a metal, and a conductive polymer. Specific examples of the material of the electrode with low light transmittance include metals such as lithium, sodium, potassium, rubidium, cesium, magnesium, calcium, strontium, barium, aluminum, scandium, vanadium, zinc, yttrium, indium, cerium, samarium, europium, terbium, and ytterbium; and alloys of two or more types of these metals, or alloys of one or more types of these metals and one or more types of metal selected from the group consisting of gold, silver, platinum, copper, manganese, titanium, cobalt, nickel, tungsten, and tin; graphite; graphite intercalation compounds; polyaniline and derivatives thereof; and polythiophene and derivatives thereof. Examples of the alloy include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

As a method for forming an electrode, any preferred publicly known formation method may be employed. Examples of the method for forming an electrode include a vacuum deposition method, a sputtering method, an ion plating method, and a plating method.

### (Active layer)

The active layer as a functional layer contains the p-type semiconductor material and/or the n-type semiconductor material described above. In the present embodiment, the active layer is preferably a solidified film of the ink composition of the present invention. The organic photoelectric conversion element may have two or more active layers.

### (Intermediate layer)

The organic photoelectric conversion element of the present embodiment may include an additional intermediate layer such as a charge transportation layer (an electron transportation layer, a hole transportation layer, an electron injection layer, and a hole injection layer) as an additional functional layer for improving characteristics such as photoelectric conversion efficiency. The intermediate layer can be formed of, for example, a solidified film of the ink composition of the present invention.

As a material used for such an intermediate layer, any preferred publicly known material can be used. Examples of the material of the intermediate layer include halides of alkaline metals such as lithium fluoride or alkaline earth metals, and oxides of these metals.

Further, examples of the material used for the intermediate layer include fine particles of an inorganic semiconductor such as titanium oxide and a mixture of PEDOT (poly(3,4-ethylenedioxythiophene)) and PSS (poly(4-styrenesulfonate)) (PEDOT : PSS).

The organic photoelectric conversion element may include a hole transportation layer between the anode and the active layer. The hole transportation layer has a function of transporting holes from the active layer to the electrode.

A hole transportation layer provided in contact with the anode may be particularly referred to as a hole injection layer. The hole transportation layer (hole injection layer) provided in contact with the anode has a function of promoting injection of holes into the anode. The hole transportation layer (hole injection layer) may be in contact with the active layer.

The hole transportation layer contains a hole transporting material. Examples of the hole transporting material include polythiophene and derivatives thereof, aromatic amine compounds, polymer compounds containing a constitutional unit having an aromatic amine residue, CuSCN, CuI, NiO, and molybdenum oxide (MoO₃).

The organic photoelectric conversion element may include an electron transportation layer between the cathode and the active layer. The electron transportation layer has a function of transporting electrons from the active layer to the cathode. The electron transportation layer may be in contact with the cathode. The electron transportation layer may be in contact with the active layer.

The electron transportation layer contains an electron transporting material. Examples of the electron transporting material include zinc oxide nanoparticles, gallium-doped zinc oxide nanoparticles, aluminum-doped zinc oxide nanoparticles, polyethyleneimine, ethoxylated polyethyleneimine, and PFN-P2.

### (Sealing layer)

The organic photoelectric conversion element of the present embodiment may further include a sealing layer. The sealing layer can be provided, for example, on a side of an electrode located farther from the substrate. The sealing layer can be formed with a material having a property of blocking moisture (water vapor barrier property) or a property of blocking oxygen (oxygen barrier property) by a method suitable for the material selected.

### (Application of organic photoelectric conversion element)

The organic photoelectric conversion element of the present embodiment can generate a photovoltaic power between the electrodes when it is irradiated with light, and thus can be operated as a solar cell. Further, the photoelectric conversion element of the present embodiment can be used as a thin film solar cell module by integrating a plurality of such solar cells.

Further, the organic photoelectric conversion element of the present embodiment allows photocurrent to flow by irradiating light from the transparent or translucent electrode side in a state in which a voltage is applied between electrodes. Thus, the photoelectric conversion element of the present embodiment can be operated as a photodetection element (photosensor). Further, the photoelectric conversion element of the present embodiment can be used as an image sensor by integrating a plurality of such photosensors.

### (Step of forming functional layer)

An ink composition containing a solvent, a p-type semiconductor material, and further, an n-type semiconductor material can be suitably used particularly for forming a bulk heterojunction-type active layer. Hereinafter, a forming step of forming an active layer as an example of a functional layer, which is a main constituent element of the organic photoelectric conversion element, by a coating method will be described. Functional layers other than the active layer (for example, an intermediate layer such as an electron transportation layer and a hole transportation layer) can also be formed in the same manner as the step of forming an active layer described below.

The ink composition for forming an active layer is applied to an object to be coated, which is selected according to the organic photoelectric conversion element and the production method thereof. In a method for producing an organic photoelectric conversion element, the ink composition for forming an active layer is applied to a functional layer that is included in the organic photoelectric conversion element and can be adjacent to the active layer.

Therefore, an object to which the ink composition for forming an active layer is applied varies depending on the layer structure of the organic photoelectric conversion element to be produced and the order of layer formation. For example, when the organic photoelectric conversion element has a layer structure of substrate/anode/hole transportation layer/active layer/electron transportation layer/cathode, and former layers described in the layer structure are formed before latter layers, an object to which the ink composition is applied is the hole transportation layer. Further, for example, when the organic photoelectric conversion element has a layer structure of substrate/cathode/electron transportation layer/active layer/hole transportation layer/anode, and former layers described in the layer structure are formed before latter layers, an object to which the ink composition is applied is the electron transportation layer.

In the present embodiment, the step of forming an active layer includes, for example, the following steps (i) and (ii).

### Step (i)

First, an ink composition is applied to an object to be coated. As a method for applying the ink composition to the object to be coated, any preferred coating method can be used. The coating method is preferably a slit coating method, a spin coating method, and a slot die coating method.

### Step (ii)

Next, the solvent is removed from the coating film of the ink composition. Any preferred method can be used as a method for removing the solvent from the coating film of the ink composition, that is, a method for forming a solidified film by drying and curing the coating film of the ink composition. Examples of the method for removing the solvent include dry treatments performed by a method of directly heating the coating film by a hot plate, a hot-air drying method, an infrared-radiation heat drying method, a flash lamp annealing method, a reduced-pressure drying method, or the like.

The step of forming an active layer may include another step in addition to the steps (i) and (ii) as long as the objects and effects of the present invention are not impaired.

In the present embodiment, the step of forming an active layer may be a step of forming two or more active layers, and may be a step in which the step (i) and the step (ii) are repeated twice or more.

### [Examples]

Hereinafter, examples will be given for further detailed description of the present invention. The present invention is not limited to the following examples.

In this example, the p-type semiconductor material and the n-type semiconductor material shown in Table 1 below were used.

### [Table 1]

**(Table 1)**

| | (Polymer) compound | Chemical structure |
|---|---|---|
| p-type semiconductor material | P-1 | 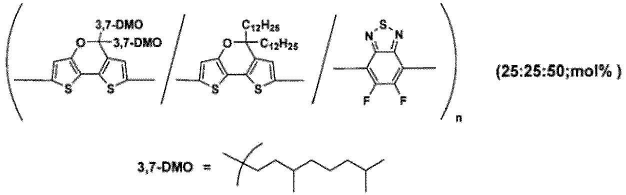 |
| n-type semiconductor material | N-1 | 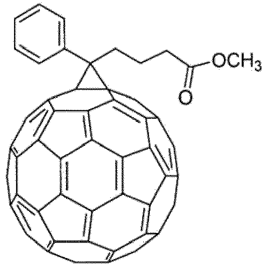 |

The polymer compound P-1 which is a π-conjugated polymer compound (D-A type conjugated polymer compound) was synthesized with reference to the method described in WO 2013/051676 and used.

As the compound N-1, C60PCBM (trade name: E100) manufactured by Frontier Carbon Corporation was used.

### [Example 1] Preparation of ink composition 1

Tetralin (relative amount area ratio of peroxide: 0.02%) was used as a solvent. A polymer compound P-1 (electron spin concentration (Spin/g) in powder: 5.80 × 10¹⁶) as a p-type semiconductor material in an amount of 1 wt.% with respect to the weight of the entire composition and a compound N-1 as an n-type semiconductor material in an amount of 2 wt.% with respect to the weight of the entire composition were mixed in the solvent. The mixture was stirred at 60°C for 8 hours to obtain an ink composition 1 according to Example 1. The measurement of the electron spin concentration in the powder of the polymer compound P-1 will be described later.

### [Examples 2 to 4 and Comparative Examples 1 and 2]

### Preparation of ink compositions 2 to 4 and ink compositions C1 and C2

An ink composition 2 according to Example 2 (electron spin concentration in powder: 16.4 × 10¹⁶), an ink composition 3 according to Example 3 (electron spin concentration in powder: 46.6 × 10¹⁶), an ink composition 4 according to Example 4 (electron spin concentration in powder: 60.1 × 10¹⁶), an ink composition C1 according to Comparative Example 1 (electron spin concentration in powder: 78.2 × 10¹⁶, molecular weight), and an ink composition C2 according to Comparative Example 2 (electron spin concentration in powder: 223 × 10¹⁶) were prepared in the same manner as in the preparation of the ink composition 1 except for using polymer compounds P-1 having different electron spin densities as described above.

The spin concentration of the powdery polymer compound P-1 increases over time due to the presence of oxygen in the atmosphere during storage, high temperature, or the like. Thus, the electron spin concentration can be adjusted by, for example, storage period and heat treatment.

### (Preparation of calibration curve)

A calibration curve showing the correlation between the amount of electron spin and the area value of the ESR spectrum was prepared. The calibration curve was prepared using TEMPO (2,2,6,6-tetramethylpiperidine 1-oxyl) as a standard substance. The preparation of the calibration curve will be specifically described below.

First, 1.05 mg of TEMPO was dissolved in 10 mL of toluene to prepare a 0.67 mM standard solution 1.

Next, 1 mL of the obtained standard solution 1 was weighed into a 10 mL measuring flask, and the volume was adjusted with toluene to prepare a 0.067 mM standard solution 2.

A 0.0067 mM standard solution 3 was prepared by performing the same operation as described above on the obtained standard solution 2, and a 0.00067 mM standard solution 4 was prepared by performing the same operation also on the obtained standard solution 3.

The ESR measurement was performed at normal temperature for each of the obtained standard solutions 1 to 4, and the area values of the obtained ESR spectra were determined. Next, a calibration curve was prepared based on the obtained area values.

The electron spin concentration per 1 g of each of the polymer compounds P-1 (p-type semiconductor material) according to Examples 1 to 4 and Comparative Examples 1 and 2 described above was measured by ESR measurement using an X-band ESR apparatus (manufactured by JEOL Ltd.).

### (Measurement of electron spin concentration of polymer compound P-1 (powder))

An amount of 5 mg of a powdery polymer compound P-1 was weighed, placed in an ESR tube (5 ϕ), and subjected to ESR measurement at normal temperature.

The amount of electron spin was quantified from the obtained area value of the ESR spectrum using the calibration curve described above. The obtained amount of electron spin was divided by the weighed value of the polymer compound P-1, and the obtained value was taken as the electron spin concentration per 1 g (Spin/g) of the polymer compound P-1. The results are shown in Table 2 below.

### (Measurement of electron spin concentration of ink composition)

An amount of 0.15 mL of each of the ink compositions according to Examples 1 to 4 and Comparative Examples 1 and 2 described above was weighed, placed in an ESR tube (5 ϕ), and subjected to ESR measurement at normal temperature.

The amount of electron spin was quantified from the obtained area value of the ESR spectrum using the calibration curve described above. The obtained amount of electron spin was divided by the weighed volume value of the ink composition, and the obtained value was taken as the electron spin concentration per 1 L (Spin/L) of the ink composition. The results are shown in Table 2 below.

### (Measurement of viscosity of ink composition)

An amount of 0.7 mL of each of the ink compositions according to Examples 1 to 4 and Comparative Examples 1 and 2 was weighed with a micropipettor and placed in a cup of an E-type viscometer (DV-2Pro, manufactured by Brookfield). The temperature of the ink composition in the cup was maintained at a constant temperature (30°C), and a measured value obtained by rotating a spindle at 10 rpm for 5 minutes was taken as viscosity (mPa·s).

The viscosity of each of the ink compositions according to Examples 1 to 4 and Comparative Examples 1 and 2 was measured 3 times. The average value and CV (coefficient of variation) (%) of the obtained viscosities were calculated. The results are shown in Table 2 below.

As is clear from Table 2, in the ink compositions 1 to 4 according to Examples 1 to 4 in which the electron spin concentration of the ink composition satisfied the requirements of the present invention, no undissolved residue was generated in the ink composition. As can be seen from the fact that lower spin densities of the polymer compound P-1 and the ink composition indicate a smaller value of CV, as the spin concentrataion of the polymer compound P-1 and the ink composition are low, the viscosity of the ink composition could be measured with high accuracy.

### (Evaluation of undissolved residue of ink composition)

For each of the ink compositions according to Examples 1 to 4 and Comparative Examples 1 and 2, the presence of an undissolved residue of the polymer compound P-1 was visually evaluated.

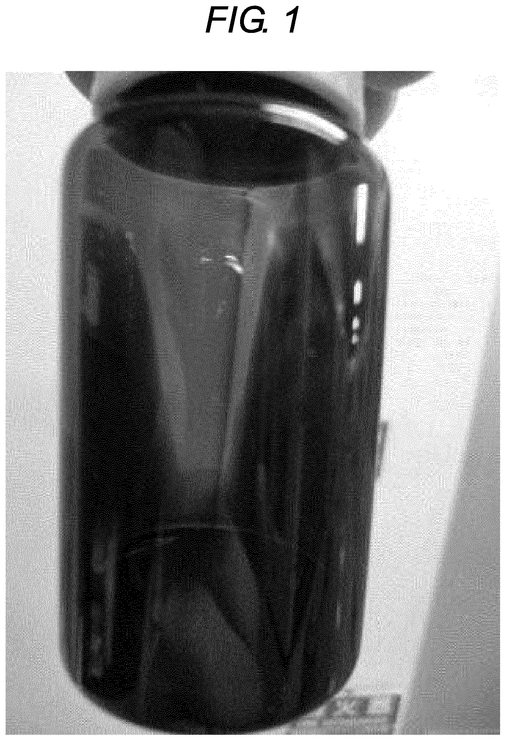

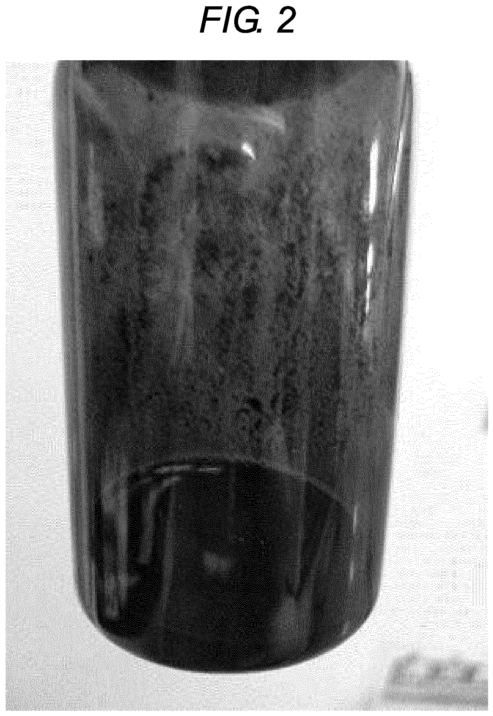

The evaluation was performed by enclosing each ink composition in a container and observing the ink composition wet-spread on the inner wall of the container with the naked eye. The results are shown in Table 2 below. Fig. 1 is a photograph for evaluation of the ink composition of Example 1, and Fig. 2 is a photograph for evaluation of the ink composition of Comparative Example 1.

As is clear from Figs. 1 and 2, no undissolved residue was observed in the ink composition 1 according to Example 1, whereas an undissolved residue was observed in some parts of the ink composition C1 according to Comparative Example 1.

### [Table 2]

**(Table 2)**

| | Electron spin concentration of polymer compound P-1 (powder) (Spin/g × 10¹⁶) | Electron spin concentration of ink composition (Spin/L × 10¹⁶) | Viscosity (mPa·s) | Average value (mPa·s) | CV (%) | Undissolved residue |
|---|---|---|---|---|---|---|
| Example 1 (ink composition 1) | 5.60 | 61.8 | 7.69 | 7.6 | 0.82 | No |
| | | | 7.57 | | | |
| | | | 7.60 | | | |
| Example 2 (ink composition 2) | 16.4 | 73.2 | 7.29 | 7.2 | 1.27 | No |
| | | | 7.11 | | | |
| | | | 7.17 | | | |
| Example 3 (ink composition 3) | 46.6 | 138 | 7.63 | 7.6 | 1.65 | No |
| | | | 7.69 | | | |
| | | | 7.45 | | | |
| Example 4 (ink composition 4) | 60.1 | 230 | 9.50 | 9.6 | 1.96 | No |
| | | | 9.47 | | | |
| | | | 9.81 | | | |
| Comparative Example 1 (ink composition C1) | 78.2 | 310 | 7.29 | 7.4 | 2.09 | Yes |
| | | | 7.42 | | | |
| | | | 7.60 | | | |
| Comparative Example 2 (ink composition C2) | 223 | 769 | 9.23 | 9.3 | 2.03 | Yes |
| | | | 9.47 | | | |
| | | | 9.10 | | | |

### (Measurement of peroxide content)

Since it is considered that the electron spin concentration also increases depending on the peroxide content in the solvent used for the ink composition, the peroxide content in the solvent used for the ink composition was measured.

The peroxide content in the solvent was measured under the following measurement conditions by a liquid chromatography apparatus equipped with an ultraviolet-visible light detector.

### <Measurement conditions>

Measuring apparatus: Shimadzu LC-20A
Column: L-Column 2 ODS (manufactured by Chemicals Evaluation and Research Institute, Japan)
Column temperature: 40°C
Mobile phase: water, acetonitrile
Flow rate: 1.0 mL/min
Detection wavelength: 230 nm (chemiluminescence detector)

Specifically, first, an ultraviolet-visible light chromatogram of a solvent was obtained through measurement using a liquid chromatography apparatus equipped with an ultraviolet-visible light detector, and an area value A of a peak derived from the solvent in the obtained ultraviolet-visible light chromatogram was calculated.

Next, a chemiluminescence chromatogram and an ultraviolet-visible light chromatogram of an aqueous solution for evaluation prepared by mixing a solvent, a chemiluminescent reagent (luminol solution), a chemiluminescent catalyst (cytochrome C), sodium hydroxide, and boric acid were obtained through measurement using a liquid chromatography apparatus equipped with a chemiluminescence detector and an ultraviolet-visible light detector. Then, an area value B of a peak of the solvent in the ultraviolet-visible light chromatogram having a retention time corresponding to a peak of the solvent in the chemiluminescence chromatogram was calculated. A value (%) obtained by multiplying the ratio (B/A) of the area value B to the area value A by 100 was determined as the relative amount value of peroxide (R). That is, the relative amount value of peroxide (R) indicates the peroxide content in the solvent based on the area value measured by a liquid chromatography apparatus.

The relative amount value of peroxide (R) of tetralin, which was a solvent used for the ink compositions (ink compositions 1 to 4 and C1) of Examples 1 to 4 and Comparative Example 1, was measured according to the section of "Measurement of peroxide content" described above, and found to be 0.02 (%).

### [Comparative Example 3] Preparation of ink composition containing solvent having higher peroxide content

An ink composition C3 was prepared in the same manner as in Example 1 except that tetralin having a relative amount value of peroxide (R) of 0.26 (%), obtained according to the section of "Measurement of peroxide content" described above was used as the solvent. The electron spin concentration and the viscosity of the ink composition were measured in the same manner as in Example 1 to calculate CV. The results are shown in Table 3 below together with the results of Example 1 for reference.

### [Table 3]

**(Table 3)**

| | Relative amount value of peroxide (R) (%) | Electron spin concentration of ink composition (Spin/L × 10¹⁶) | Viscosity (mPa·s) | CV (%) |
|---|---|---|---|---|
| Example 1 (ink composition 1) | 0.02 | 61.8 | 7.69 | 0.82 |
| | | | 7.57 | |
| | | | 7.60 | |
| Comparative Example 3 (ink composition C3) | 0.26 | 319.6 | 5.77 | 4.00 |
| | | | 6.13 | |
| | | | 6.23 | |

### [Example 5] Examination of mechanism by quantum chemical calculation

In order to examine the mechanism of the increase in viscosity and CV of the ink composition with the increase in electron spin concentration, quantum chemical calculation was performed.

First, as a model compound of the polymer compound P-1, the number of units in which a D constitutional unit having a structure in which bithiophene is cyclized and an A constitutional unit having a benzothiazole ring structure are bonded to each other (hereinafter, referred to as a D-A repeating unit), namely, the number of D-A repeating units (n) was set to 1, 2, or 3, and calculation was performed for each case.

In addition, optimization of the structure of a neutral-neutral complex and a neutral-radical cation complex was performed using a dimer in which two polymer (polymer compound P-1) chains are associated as an aggregation model.

As the aggregation stabilization energy, a difference (B-A) between a value (A) obtained by adding energy values obtained by optimization of the structure for each polymer chain and an energy value (B) obtained by structure optimization calculation of the dimer was determined, and the obtained value (B-A) was defined as the aggregation stabilization energy.

In the above examination, Gaussian 09 and Revision E.01 (Gaussian, Inc.) were used as programs, M06 was used as a functional, and 6-31G(d) was further used as a basis function. The results are shown in Table 4 below.

### [Table 4]

**(Table 4)**

| | Number of D-A repeating units (n) | Aggregation stabilization energy (kcal/mol) |
|---|---|---|
| Neutral-neutral complex | n = 1 | 22.1 |
| | n = 2 | 45.2 |
| | n = 3 | 67.2 |
| Neutral-radical cation complex | n = 1 | 28.9 |
| | n = 2 | 49.6 |
| | n = 3 | 71.0 |

Table 4 reveals that a neutral-radical cation complex formed of a neutral polymer and a radical cation having an increased electron spin concentration can acquire higher aggregation stabilization energy as compared with a neutral-neutral complex formed of neutral polymers (polymer compound P-1) with no increase in electron spin concentration. That is, it means that the neutral-radical cation complex requires higher energy in order to eliminate the aggregation state.

Therefore, it is considered that the polymer having an increased electron spin concentration becomes a radical cation in the ink composition (solvent) and further forms a neutral-radical cation complex, making it difficult to eliminate the aggregation state, and as a result, an undissolved residue is likely to occur, which affects the viscosity and CV.

It is considered that, when a part of the polymer is oxidized by peroxides in the solvent to become a radical cation, the polymer forms a neutral-radical cation complex during the preparation of the ink composition, which increases the electron spin concentration and causes formation of aggregations. As a result, it is considered that the neutral-radical cation complex in the ink composition remains as an undissolved component, and thus the viscosity and CV increased.

## Claims

1. An ink composition for forming a functional layer of an organic photoelectric conversion element, wherein an electron spin concentration per 1 L of volume of the ink composition is 250 × 10¹⁶ or less.

2. The ink composition according to claim 1, comprising a solvent and a p-type semiconductor material.

3. The ink composition according to claim 1 or 2, wherein the p-type semiconductor material contains a polymer compound having an electron spin concentration per 1 g of weight of 70 × 10¹⁶ or less.

4. The ink composition according to any one of claims 1 to 3, wherein
the solvent contains one or more types of organic solvents, and
the p-type semiconductor material contains a π-conjugated polymer compound containing a donor constitutional unit and an acceptor constitutional unit.

5. The ink composition according to any one of claims 1 to 4, further comprising
an n-type semiconductor material, wherein
the functional layer is an active layer.

6. The ink composition according to any one of claims 1 to 5, wherein the solvent contains an organic solvent having a relative amount value of peroxide of 0.2 (%) or less based on an area value measured by a liquid chromatography apparatus.

7. The ink composition according to any one of claims 1 to 4, wherein the solvent contains a compound represented by following Formula (1): 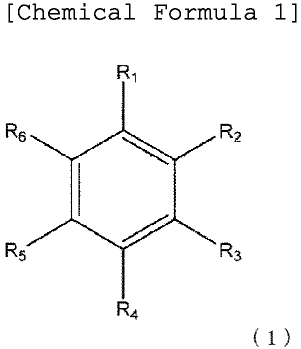 where R₁, R₂, R₃, R₄, R₅, and R₆ each independently represent a hydrogen atom, an alkyl group, or a cycloalkyl group, and two adjacent groups among R₁, R₂, R₃, R₄, R₅, and R₆ may be bonded to each other to form a ring.

8. A method for producing an ink composition for forming a functional layer of an organic photoelectric conversion element, the method comprising a step of dissolving a p-type semiconductor material containing a polymer compound having an electron spin concentration per 1 g of weight of 70 × 10¹⁶ or less in a solvent.

9. The method for producing an ink composition according to claim 8, wherein the ink composition is an ink composition having an electron spin concentration per 1 L of volume of 250 × 10¹⁶ or less.

10. The method for producing an ink composition according to claim 8 or 9, wherein the solvent contains an organic solvent having a relative amount value of peroxide of 0.2 (%) or less based on an area value measured by a liquid chromatography apparatus.
